# EUROPÄISCHE PATENTSCHRIFT

(11) **EP 2 533 425 B1**
(45) Veröffentlichungstag und Bekanntmachung des Hinweises auf die Patenterteilung: **18.03.2015**
(21) Anmeldenummer: 12170151.0
(22) Anmeldetag: 31.05.2012
(51) Int. Cl.: H03K 17/95, H03K 17/97, F24C 7/08

(54) **Bedienvorrichtung für ein Haushaltsgerät und Verfahren zum Bedienen eines Haushaltsgeräts**
Operating device for a domestic appliance and method for operating a domestic appliance
Système de commande pour un appareil ménager et procédé de commande d'un appareil ménager

(30) Priorität: 08.06.2011 DE 102011077168
(43) Veröffentlichungstag der Anmeldung: 12.12.2012
(73) Patentinhaber: BSH Bosch und Siemens Hausgeräte GmbH, 81739 München (DE)
(72) Erfinder: Huber, Johann, 83334 Inzell (DE); Makhtyuk, Roman, 93087 Alteglofsheim (DE); Marbach, Andreas, 83374 Traunwalchen (DE); Schemmerer, Roman, 83349 Palling (DE)

(56) Entgegenhaltungen:
- EP-A2- 1 014 001
- WO-A1-2005/038350
- DE-A1-102009 045 129

## Beschreibung

Die Erfindung betrifft eine Bedienvorrichtung für ein Haushaltsgerät, insbesondere für ein Kochfeld, aufweisend eine Trägerplatte, ein ortsfest angeordnetes Gehäuse mit einem darin für eine begrenzte Strecke beweglich untergebrachten Magneten, ein oberhalb des Gehäuses angeordnetes bewegliches Bedienteil, welches dazu eingerichtet ist, mit dem Magneten magnetisch zu koppeln und bei seiner Bedienung eine Bewegung des Magneten in dem Gehäuse zu bewirken, und mindestens einen unterhalb der Trägerplatte angeordneter Sensor, mittels dessen eine Position des mindestens einen Sensors feststellbar ist. Das Verfahren dient zum Betätigen oder Bedienen eines Haushaltsgeräts.

WO 2005/038350 A1 offenbart eine Bedienvorrichtung in Form eines Schiebereglers mit einem Schiebe-Magneten, welcher auf einer Glaskeramikplatte läuft. An einer unter der Glaskeramikplatte angeordneten, wellenförmigen Rastkulisse mit Kulissenbahn kann ein walzenförmiger Rast-Magnet bewegt werden, wobei diese Bewegung die Rastmöglichkeiten beinhaltet. Über Feststellung der Position des Rast-Magneten können verschiedene Positionen und somit verschiedene Funktionen angesteuert werden.

Es ist die **Aufgabe** der vorliegenden Erfindung, die Nachteile des Standes der Technik zu überwinden und eine besonders flexible, kompakte und einfach umzusetzende Bedienmöglichkeit, insbesondere Schaltmöglichkeit, für ein Haushaltsgerät bereitzustellen.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch eine Bedienvorrichtung für ein Haushaltsgerät, aufweisend: (a) eine Trägerplatte, (b) ein ortsfest angeordnetes Gehäuse mit einem darin für eine begrenzte Strecke beweglich untergebrachten Magneten, (c) ein oberhalb des Gehäuses angeordnetes bewegliches Bedienteil, welches dazu eingerichtet ist, mit dem (in dem Gehäuse befindlichen) Magneten magnetisch zu koppeln und bei seiner Bedienung (insbesondere Bewegung) eine Bewegung des Magneten in dem Gehäuse zu bewirken, und (d) mindestens einen unterhalb der Trägerplatte angeordneter Sensor, mittels dessen eine Position des Magneten feststellbar ist, wobei (e) das Gehäuse oberhalb der Trägerplatte angeordnet ist und (f) das Bedienteil mehrere voneinander beabstandete Koppelelemente aufweist, welche jeweils dazu eingerichtet sind, mit dem Magneten magnetisch zu koppeln, und welche das Gehäuse bei einer Bedienung des Bedienteils überstreichen können, insbesondere auch über den Rand des Gehäuses hinaus.

Dasjenige Koppelelement, welches sich am nächsten an dem Magneten befindet, bestimmt aufgrund der magnetischen Kopplung die Position des Magneten und damit auch dessen Bewegung. Insbesondere entspricht (in Draufsicht) eine Position des Magneten der Position des nächstgelegenen Koppelelements. Wird dieses nächstgelegene Koppelelement aufgrund einer Bedienung des Bedienteils bewegt, beispielsweise ausgehend von einer Ausgangsposition, bewegt sich der Magnet in dem Gehäuse entsprechend mit. Dadurch, dass der Magnet in dem Gehäuse nur für eine begrenzte Strecke beweglich ist (z.B. begrenzt durch eine Länge des Gehäuses), schlägt der Magnet jedoch an dem Gehäuse an, wenn das Koppelelement über das Gehäuse hinaus bewegt wird. Mit steigender Entfernung dieses Koppelelements schwächt sich dessen magnetische Kopplung mit dem Magneten ab, gleichzeitig verstärkt sich die magnetische Kopplung mit dem folgenden, beabstandeten Koppelelement, welches dem Magneten näherkommt. Ab einer bestimmten Position des Bedienteils wird die magnetische Kopplung zu dem folgenden Koppelelement dominant, und der Magnet bewegt sich zurück auf eine Position, welche durch die Position des folgenden Koppelelements gegeben ist. Diese Position kann insbesondere wieder der Ausgangsposition entsprechen. Aufgrund einer Bewegung des Bedienteils kann der Magnet folglich in dem Gehäuse eine definierte Strecke aus einer Ausgangsposition ausgelenkt werden und wieder in die Ausgangsposition zurückgebracht werden. Eine solche Auslenkung oder Bewegung des Magneten kann einem Schaltvorgang gleichgesetzt werden. Das Überstreichen kann also insbesondere auch ein Hinausbewegen eines Koppelelements über das Gehäuse hinaus und/oder von einer Position außerhalb oder seitlich des Gehäuses auf eine Position oberhalb des Gehäuses umfassen. Es ist also für einen Übergang zwischen zwei (Schalt-)Stellungen nicht notwendig, dass das Koppelelement das Gehäuse über seine gesamte Ausdehnung, z.B. Länge, überstreicht. Das Überstreichen kann also ein vollständiges als auch ein teilweises Überstreichen des Gehäuses umfassen.

Dadurch, dass das Gehäuse oberhalb der Trägerplatte angeordnet ist, können die Koppelelemente nahe an dem Magneten vorbeigeführt werden und folglich den Magneten sicher bewegen. Die Auslenkbewegung ist durch den mindestens einen Sensor einfach und sicher feststellbar. Zudem lassen sich so unbegrenzt Auslenkvorgänge (und damit auch Schaltvorgänge) durchführen, wodurch sich diese Bedienvorrichtung insbesondere ohne oder mit nur geringfügigen Anpassungen für eine Vielzahl von Anwendungen nutzen lässt.

Es ist ein weiterer Vorteil, dass Auslenkungen in beide Richtungen ermöglicht werden. Eine Einstellung einer Schaltempfindlichkeit ist einfach mittels einer Variation eines Abstands zwischen benachbarten Koppelelementen und/oder durch eine Einstellung der Strecke, die sich der Magnet in dem Gehäuse bewegen kann (z.B. durch eine Länge des Gehäuses) einstellbar. Ferner kann das Gehäuse einfach ausgestaltet sein, z.B. ohne eine Rastkulisse o.ä. Darüber hinaus wird einem Bediener aufgrund der sich verändernden Kopplungsstärke nach Anschlag des Magneten in dem Gehäuse eine gute haptische Rückmeldung gegeben. Auch erzeugt der Anschlag des Magneten an dem Gehäuse ein Geräusch, welches für eine akustische Rückmeldung an den Bediener und/oder für eine Detektion des Anschlags über einen Auslenkvorgang nutzbar ist.

Der Magnet kann beispielsweise kugelförmig, scheibenförmig oder walzenförmig ausgestaltet sein.

Die Trägerplatte kann insbesondere eine Kochfeldplatte sein, z.B. aus Glaskeramik. Das Haushaltsgerät kann insbesondere ein die Kochfeldplatte aufweisendes Elektrogerät sein, z.B. ein Kochfeld oder ein Herd. Jedoch ist die Bedienvorrichtung nicht darauf beschränkt. So mag die Trägerplatte auch einer Abdeckplatte einer Bedienblende usw. entsprechen, z.B. eines Ofens, eines Wäschebehandlungsgeräts, eines Haushaltskleingeräts u.v.m.

Es ist eine Ausgestaltung, dass sich zu einem Zeitpunkt nur eines der Koppelelemente oberhalb des Gehäuses befindet und dass in einer ersten Stellung des Bedienteils sich ein erstes Koppelelement in einer Position oberhalb des Gehäuses befindet und sich der Magnet an einer korrespondierenden Position in dem Gehäuse befindet, und dass bei einem Übergang zu einer zweiten Stellung das erste Koppelelement neben das Gehäuse bewegbar ist, so dass der Magnet an das Gehäuse anschlägt, und ein zu dem ersten Koppelelement benachbartes zweites Koppelelement in eine Position oberhalb des Gehäuses bewegbar ist, so dass der Magnet folgend aus dem Anschlag in eine Position bewegbar ist, welche der Position des zweiten Koppelelements entspricht. Diese Ausgestaltung ermöglicht eine besonders präzise und eindeutige Auslenkung des Magneten.

Jedoch ist es grundsätzlich auch möglich, dass sich zwei oder sogar noch mehr Koppelelemente gleichzeitig oberhalb des Gehäuses befinden.

Es ist noch eine Ausgestaltung, dass das Bedienteil ein drehbares Bedienteil ist und mehrere sternförmig angeordnete, insbesondere geradlinige, Koppelelemente aufweist. Der gemeinsame Mittelpunkt der Koppelelemente kann auf einer Drehachse des Bedienteils liegen. So können durch eine Drehbewegung des Bedienteils Auslenkungen und damit (je nach datentechnischer oder steuerungstechnischer Behandlung der detektierten Auslenkungen) Schaltvorgänge ausgelöst werden, insbesondere auch in beide Richtungen. Das Bedienteil kann insbesondere als ein Drehknebel ausgestaltet sein.

Es ist eine Weiterbildung, dass die Koppelelemente drehsymmetrisch angeordnet sind. So können in Bezug auf eine Drehstellung des Bedienteils gleichartige Auslenkungen über eine volle Drehung des Bedienteils ermöglicht werden.

Es ist eine alternative Weiterbildung, dass die Koppelelemente sektorweise angeordnet oder vorhanden sind (also nicht vollständig drehsymmetrisch). Dies ermöglicht ein kompaktes Bedienteil, welches zudem einem Bediener eine nur begrenzte Zahl von Auslenkungen oder Schaltvorgängen nahelegt. Diese begrenzte Zahl von Auslenkungen kann durch eine, z.B. mechanische, Begrenzung der Drehmöglichkeit des Bedienteils vorgegeben sein oder durch eine für einen Bediener ungewöhnliche oder ungünstige Handhabung bei einer Weiterdrehung über den vorgesehenen Drehbereich hinaus. Die nur sektorweise Anordnung kann beispielsweise eine Anordnung der Koppelelemente in einem Halbkreis sein.

Es ist noch eine weitere Ausgestaltung, dass das Bedienteil ein längsverschiebliches Bedienteil ist und mehrere parallel angeordnete Koppelelemente aufweist. So können Auslenkungen und Schaltvorgänge durch eine lineare Bewegung des Bedienteils ausgelöst werden, insbesondere auch in beide Richtungen. Die Koppelelemente können insbesondere äquidistant zueinander angeordnet sein, müssen es aber nicht sein.

Es ist auch eine Ausgestaltung, dass die Koppelelemente ferromagnetische Streben sind. Die ferromagnetischen Streben können eine ausreichende magnetische Kopplung mit dem Magneten erzeugen, sind preiswert herstellbar und erlauben eng aufeinanderfolgende Schaltvorgänge. Die ferromagnetischen Streben können insbesondere Eisen aufweisen, z.B. in Form einer Eisen-Legierung, insbesondere zusammen mit Nickel und/oder Kobalt. Alternativ können die Streben (oder andere beabstandete Elemente) dauermagnetisch sein oder dauermagnetische Bereiche aufweisen, was eine Kopplung verstärkt.

Der Anschlag an dem Gehäuse erzeugt ein hörbares Geräusch, das als akustische Rückmeldung nutzbar ist. Für eine Einstellung, insbesondere Dämpfung, einer Lautstärke des Anschlagsgeräuschs kann es eine Ausgestaltung sein, dass das Gehäuse (genauer gesagt der Innenraum des Gehäuses, in welchem sich der Magnet befindet) mit einem Dämpfungsmedium gefüllt ist. Dieses Dämpfungsmedium verringert eine Geschwindigkeit des Magneten und damit eine Lautstärke bei einem Anschlag. Das Dämpfungsmedium kann beispielsweise eine Flüssigkeit oder ein Gel sein.

Es ist eine alternative oder zusätzliche Ausgestaltung, um eine Lautstärke des Anschlagsgeräuschs zu verringern, dass ortsfest an einer Außenseite mindestens eines Anschlagsbereichs des Gehäuses ein Magnet ("Anschlagsmagnet") angeordnet ist, welcher den Magneten in dem Gehäuse abstößt. Diese Ausgestaltung weist den Vorteil auf, dass die Anschlagsmagnete so dimensioniert und eingestellt werden können, dass eine Bewegung des Magneten in dem Gehäuse im Wesentlichen nur an einem Anschlagsbereich in seiner Bewegung gedämpft wird. Dies verhindert einen möglichen Verlust einer Mitführung mit dem dominant koppelnden Koppelelement bei einer schnellen Bewegung des Koppelelements. Die Anschlagsmagneten können auch als Rastmagnete oder Befestigungsmagnete für ein abnehmbares Bedienteil dienen.

Es ist ferner eine Ausgestaltung, dass ein Innenraum des Gehäuses eine Führung für den Magneten darstellt. Dies unterstützt eine definierte Bewegung des Magneten und einen präzisen Schaltvorgang. Die Führung kann insbesondere eine Bewegung des Magneten auf einer linearen (geradlinigen und/oder gekrümmten) Bahn erlauben. Der Innenraum kann beispielsweise als eine endseitig begrenzte Laufbahn für einen kugelförmigen oder walzenförmigen Magneten ausgebildet sein. Der walzenförmige Magnet kann insbesondere rollend oder (insbesondere in seiner Längsrichtung) gleitend in dem Gehäuse beweglich untergebracht sein.

Es ist eine Weiterbildung, dass dann, wenn das Bedienteil ein drehbares Bedienteil ist, der Innenraum eine Krümmung aufweist, die einer Bahn eines das Gehäuse überstreichenden festen Punkts auf dem Koppelelement entspricht. Dies ermöglicht eine Bewegung des Magneten in dem Innenraum mit gleichbleibender Kraft. Jedoch ist auch ein geradliniger Innenraum verwendbar, was eine Anpassung an unterschiedliche Bedienteile gering hält.

Es ist noch eine Weiterbildung, dass dann, wenn das Bedienteil ein längsverschiebliches Bedienteil ist, der Innenraum ein geradliniger Innenraum ist. Auch dies ermöglicht eine Bewegung des Magneten in dem Innenraum mit gleichbleibender Kraft.

Es ist außerdem eine Ausgestaltung, dass der mindestens eine Sensor mindestens einen Magnetfeldsensor umfasst. Diese Ausgestaltung weist den Vorteil auf, dass der Magnet als solches bereits das Magnetfeld erzeugt, welches mittels des mindestens einen Magnetfeldsensors abfühlbar ist. Folglich wird ohne weiteren Aufwand eine sichere Detektion einer Position (insbesondere einer Anschlagposition, aber z.B. auch einer Ausgangsposition o.ä.) des Magneten, und damit dessen Schaltstellung (z.B. "schaltend" / "nichtschaltend"), ermöglicht. Dadurch, dass der Magnet aktiv ein Magnetfeld erzeugt, braucht der mindestens eine Magnetfeldsensor nicht sehr nahe an dem Gehäuse angeordnet zu sein, sondern kann auch in einiger Entfernung davon angeordnet sein. So kann auf einen erhöhten Aufwand zur Annäherung des Sensors an das Gehäuse verzichtet werden, z.B. ein Vorsehen einer besonders dünnen Trägerplatte, eine besonders geringe Bauhöhe einer den mindestens einen Magnetfeldsensor tragenden Leiterplatte oder Platine, eine unmittelbare Anordnung des Sensors an der Trägerplatte usw.

Es ist eine für eine sichere Detektion der Position des Magneten mittels eines Magnetfeldsensors mit geringem Aufwand vorteilhafte Weiterbildung, dass die Trägerplatte nichtmagnetisch, insbesondere elektrisch nichtleitend ist, z.B. eine Platte aus Keramik, Glaskeramik, Kunststoff oder Holz. So kann die Trägerplatte ein von dem Magneten erzeugtes Magnetfeld im Wesentlichen ungehindert durchlassen.

Es ist noch eine Ausgestaltung, dass die Bedienvorrichtung ein Magnetfeld-Führungselement, z.B. einen Stift aus Weicheisen oder einem Mu-Metall, aufweist, welches das von dem Magneten, insbesondere das von dem sich am Anschlag befindlichen Magneten, erzeugte Magnetfeld (lokal stärker oder verstärkt) führt. So kann das Magnetfeld gezielt gerichtet werden, insbesondere zu dem Magnetfeldsensor. Der Magnetfeldsensor kann folglich noch weiter von dem Magneten angeordnet sein und/oder flexibler positioniert werden. Auch kann das Magnetfeld so durch eine elektrisch leitfähige Trägerplatte hindurchgeführt werden. Dazu mag das eine Magnetfeld-Führungselement gegenüber der Trägerplatte elektrisch isoliert sein und/oder eine signifikant höhere Permeabilitätszahl aufweisen als das Material der Trägerplatte, z.B. mehr als 3.000, insbesondere mehr als 10.000. Das Magnetfeld-Führungselement kann aber auch durch eine nichtmagnetische, insbesondere elektrisch nichtleitende, Trägerplatte (z.B. eine Glaskeramikplatte) geführt sein.

Es ist eine Weiterbildung, dass das Magnetfeld-Führungselement sich von einer Position unterhalb des Gehäuses, insbesondere entsprechend einer Position des sich am Anschlag befindlichen Magneten, zu einem Magnetfeldsensor erstreckt.

Der Magnetfeldsensor kann insbesondere ein Hallsensor sein. Ein Hallsensor ist messempfindlich, robust und kompakt. Alternativ mag der Magnetfeldsensor beispielsweise ein AMR (Anisotroper Magnetoresistiver Effekt)-Sensor, ein GMR- oder Riesenmagnetowiderstands-Sensor, ein CMR (Kolossaler Magnetoresistiver Effekt)-Sensor, ein TMR (magnetischer Tunnelwiderstands)-Sensor, ein SQUID-Sensor, ein Reed-Schalter o.ä. sein.

Jedoch ist der mindestens eine Sensor nicht auf einen Magnetfeldsensor beschränkt. Alternativ oder zusätzlich mag mindestens ein Sensor ein optischer Sensor sein. Der optische Sensor kann beispielsweise einen sich an einem Anschlag oder an einer Ausgangsposition o.ä. befindlichen Magneten optisch detektieren, z.B. nach dem Prinzip einer (reflektierenden) Lichtschranke. Der optische Sensor mag dazu z.B. einen Lichtemitter auf der Basis sichtbaren Lichts und /oder von Infrarotlicht aufweisen, und einen entsprechenden Detektor. Der Emitter kann insbesondere ein Laser sein, z.B. eine Laserdiode. Der Magnet mag eine reflektierende Oberfläche aufweisen, was eine Reflexion verstärkt.

Es ist noch eine Weiterbildung, dass der mindestens eine Sensor einen akustischen Sensor umfasst, welcher ein Anschlagsgeräusch (Geräusch bei Anschlag des Magneten an dem Gehäuse, entsprechend einer Endlage oder Anschlagsposition des Magneten) detektiert.

Es ist zudem eine Ausgestaltung, dass das Bedienteil abnehmbar ist. Dies erleichtert eine Reinigbarkeit der Bedienvorrichtung und ermöglicht eine besonders hochwertige Anmutung.

Die Aufgabe wird auch gelöst durch ein Verfahren zum Bedienen eines Haushaltsgeräts gemäß Anspruch 13.

In den folgenden Figuren wird die Erfindung anhand von Ausführungsbeispielen schematisch genauer beschrieben. Dabei können zur Übersichtlichkeit gleiche oder gleichwirkende Elemente mit gleichen Bezugszeichen versehen sein.
- Fig.1: zeigt in einer Ansicht von unten ein Bedienteil und ein Gehäuse mit einem darin enthaltenen Magneten, welche einen Teil einer erfindungsgemäßen Bedienvorrichtung gemäß einem ersten Ausführungsbeispiel darstellen, und zwar in einer ersten Betätigungsstellung;
- Fig.2: zeigt als Schnittdarstellung in Seitenansicht die Bedienvorrichtung gemäß dem ersten Ausführungsbeispiel in der ersten Betätigungsstellung;
- Fig.3: zeigt das Bedienteil und das Gehäuse mit dem darin enthaltenen Magneten der Bedienvorrichtung gemäß dem ersten Ausführungsbeispiel bei einem Übergang zu einer zweiten Betätigungsstellung;
- Fig.4: zeigt als Schnittdarstellung in Seitenansicht die Bedienvorrichtung gemäß dem ersten Ausführungsbeispiel bei dem Übergang zu der zweiten Betätigungsstellung;
- Fig.5: zeigt das Bedienteil und das Gehäuse mit dem darin enthaltenen Magneten der Bedienvorrichtung gemäß dem ersten Ausführungsbeispiel in der zweiten Betätigungsstellung;
- Fig.6: zeigt als Schnittdarstellung in Seitenansicht die Bedienvorrichtung gemäß dem ersten Ausführungsbeispiel in der zweiten Betätigungsstellung;
- Fig.7: zeigt in einer Ansicht von unten ein Bedienteil und ein Gehäuse mit einem darin enthaltenen Magneten, welche einen Teil einer erfindungsgemäßen Bedienvorrichtung gemäß einem zweiten Ausführungsbeispiel darstellen;
- Fig.8: zeigt als Schnittdarstellung in Seitenansicht die Bedienvorrichtung gemäß dem zweiten Ausführungsbeispiel;
- Fig.9: zeigt in einer Ansicht von unten ein Bedienteil und ein Gehäuse mit einem darin enthaltenen Magneten, welche einen Teil einer erfindungsgemäßen Bedienvorrichtung gemäß einem dritten Ausführungsbeispiel darstellen;
- Fig.10: zeigt in einer Ansicht von unten ein Bedienteil und ein Gehäuse mit einem darin enthaltenen Magneten, welche einen Teil einer erfindungsgemäßen Bedienvorrichtung gemäß einem vierten Ausführungsbeispiel darstellen; und
- Fig.11: zeigt als Schnittdarstellung in Seitenansicht eine Bedienvorrichtung gemäß einem fünften Ausführungsbeispiel.

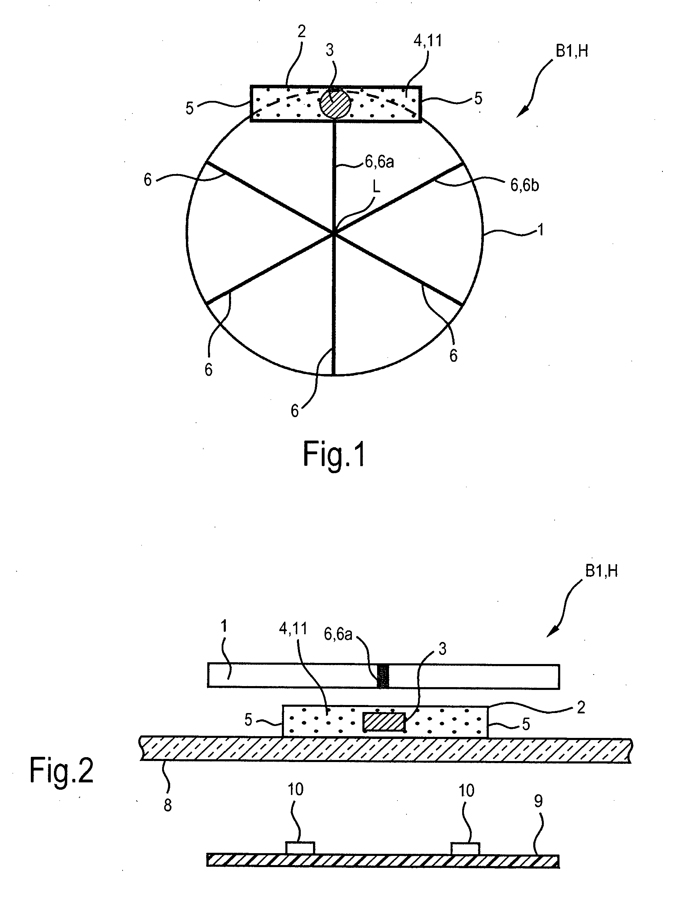

**Fig.1** zeigt in einer Ansicht von unten ein bewegliches Bedienteil 1 und ein ortsfestes Gehäuse 2 mit einem darin beweglich gelagerten Magneten 3, welche einen Teil einer Bedienvorrichtung B1 gemäß einem ersten Ausführungsbeispiel darstellen. Die Bedienvorrichtung B1 ist hier Teil eines Haushaltsgeräts H in Form eines Kochfelds. Das Bedienteil 1 ist als ein um seine Drehachse L frei drehbarer Drehknebel ausgestaltet, welcher im Wesentlich oberhalb des Gehäuses 2 angeordnet ist. Das Gehäuse 2 weist einen geradlinigen Innenraum 4 auf, in welchem der Magnet 3 entsprechend geradlinig bewegbar geführt ist. Folglich kann sich der Magnet 3 entlang der Längserstreckung des Innenraums 4 bis zu Seitenwänden 5 für diese begrenzte Strecke frei bewegen. Die Seitenwände 5 stellen beidseitige Anschläge für den Magneten 4 dar. Der Magnet 3 ist hier kreisscheibenartig oder stehend zylinderförmig ausgebildet.

Für eine definierte Bewegung des Magneten 3 in dem Gehäuse 2, genauer: in dessen Innenraum 4, weist das Bedienteil 1 mehrere voneinander beabstandete Koppelelemente in Form von sternförmig und gleichwinklig um die Drehachse L angeordneten Streben 6 auf. Die Streben 6 sind also drehsymmetrisch zu der Drehachse L angeordnet. Die Streben 6 weisen hier ferromagnetisches Material auf, z.B. Eisen. Folglich können die Streben 6 magnetisch mit dem Magneten 3 koppeln, wobei diejenige Strebe 6, 6a am stärksten mit dem Magneten 3 koppelt, welche dem Magneten 3 am nächsten kommt. Die ferromagnetischen Streben 6 weisen für eine starke Kopplung bevorzugt eine Permeabilitätszahl von mehr als 300 auf. Das Gehäuse 2 besteht für eine starke Kopplung vorzugsweise aus einem nichtmagnetischen, insbesondere elektrisch nichtleitenden, Material, insbesondere aus Kunststoff. Unter einem nichtmagnetischen Material kann insbesondere ein Material mit einer geringen, insbesondere vernachlässigbaren, magnetischen Permeabilität verstanden werden.

Während einer Drehbewegung um die Drehachse L können die Streben 6 das Gehäuse 2 oberhalb überstreichen, und zwar bei der Bedienvorrichtung B1 so, dass sich zu einem Zeitpunkt jeweils nur eine Strebe 6 oberhalb des Gehäuses 2 befindet.

In der hier gezeigten ersten Betätigungsstellung befindet sich eine Strebe 6a mittig über dem Gehäuse 2. Aufgrund der magnetischen Kopplung des Magneten 3 mit dieser Strebe 6a befindet sich der Magnet 3 mittig in dem Gehäuse 2 und damit an einer Position, welche (in Draufsicht) der Position der Strebe 6a korrespondiert oder entspricht ("Ausgangsposition"). Die Position der Strebe 6a oberhalb des Gehäuses 2 bestimmt oder definiert also die Position des Magneten 3.

**Fig.2** zeigt als Schnittdarstellung in Seitenansicht die Bedienvorrichtung B1 in der ersten Betätigungsstellung. Das Bedienteil 1, insbesondere dessen Streben 6, befindet sich oberhalb des Gehäuses 2. Das Gehäuse 2 ist oberhalb einer Trägerplatte 8 in Form z.B. einer Glaskeramikplatte oder Kunststoffplatte, angeordnet, z.B. daran festgeklebt.

Unterhalb der Trägerplatte 8 befindet sich beabstandet eine Sensoreinrichtung 9 mit zwei Sensoren in Form von Magnetfeldsensoren 10. Die Magnetfeldsensoren 10 befinden sich unterhalb derjenigen Position des Magneten 3, an welchem er an einer der Seitenwände 5 anschlägt ("Anschlagsposition"). Die Magnetfeldsensoren 10 können also ein Vorhandensein des Magneten 3 in seinen Anschlagspositionen detektieren.

Das Bedienteil 1 ist ferner abnehmbar und mag beispielsweise mittels einer magnetischen Kraft drehbar an der Trägerplatte 8 gehalten werden.

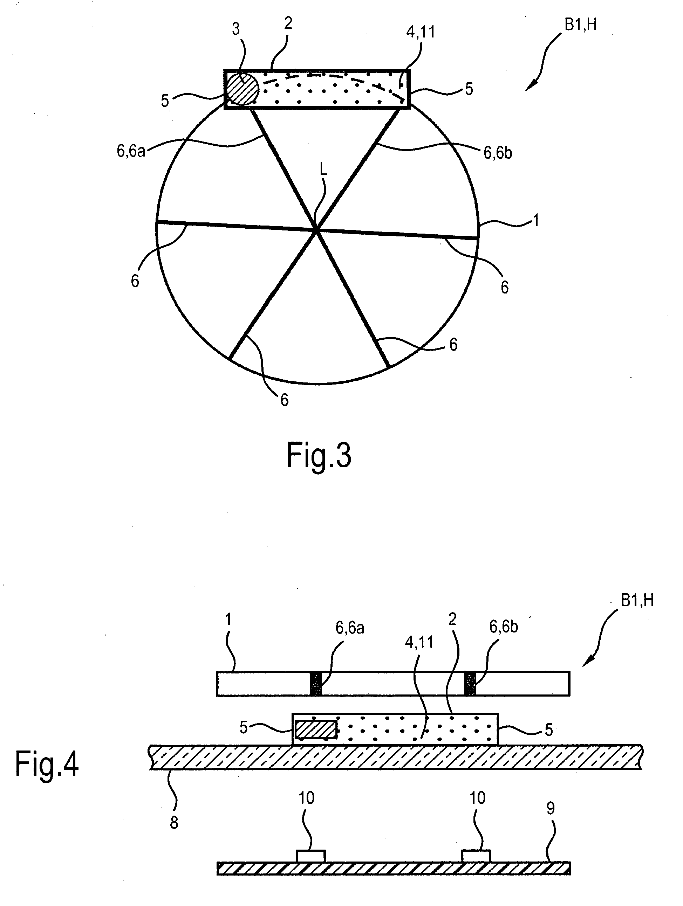

**Fig.3** zeigt das Bedienteil 1 und das Gehäuse 2 mit dem darin enthaltenen Magneten 3 bei einem Übergang zu einer zweiten Betätigungsstellung, d.h. einer Stellung, welche durch ein Betätigen des Bedienteils 1 durch einen Bediener oder Nutzer zustande gekommen ist. **Fig.4** zeigt als Schnittdarstellung in Seitenansicht die Bedienvorrichtung B1 in der zweiten Betätigungsstellung. In der zweiten Betätigungsstellung ist das Bedienteil 1 so weit gegen den Uhrzeigersinn verdreht worden, dass die mit dem Magneten 3 am stärksten koppelnde Strebe 6a den Magneten 3 auf Anschlag (in Anschlagsposition) mit der hier linken Seitenwand 5 des Gehäuses 2 gebracht hat. Denn die Bewegung der Strebe 6a wird aufgrund der magnetischen Kopplung von dem Magneten 3, projiziert auf die Längserstreckung des Innenraums 4, mitgemacht. Die Drehung des Bedienteils 1 bewirkt also eine lineare Bewegung des Magneten 3 in dem Gehäuse 2.

Aufgrund dieser Auslenkung des Magneten 3 wird das durch den Magneten 3 erzeugte Magnetfeld am Ort des korrespondierenden (hier: linken) Magnetfeldsensors 10 verstärkt, was durch diesen Magnetfeldsensor 10 detektierbar ist. Diese Auslenkung des Magneten 3 kann als ein Schaltvorgang interpretiert werden oder für einen Schaltvorgang verwendet werden, beispielsweise mittels einer mit der Sensoreinrichtung 9 gekoppelten Steuereinrichtung des Haushaltsgeräts H.

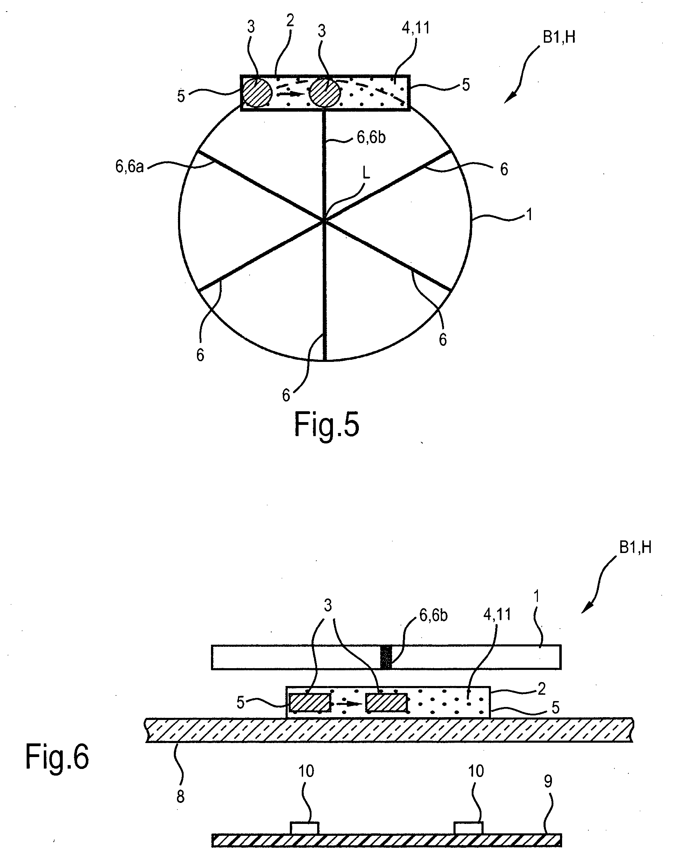

**Fig.5** zeigt das Bedienteil 1 und das Gehäuse 2 mit dem darin enthaltenen Magneten 3 in der zweiten Betätigungsstellung. **Fig.6** zeigt als Schnittdarstellung in Seitenansicht die Bedienvorrichtung B1 in der zweiten Betätigungsstellung. In der zweiten Betätigungsstellung nimmt eine der Strebe 6a in Drehrichtung folgende Strebe 6b die Stellung der Strebe 6a in der ersten Betätigungsstellung ein.

Dabei befindet sich der Magnet 3 nun wieder mittig in dem Gehäuse 2, weil mit dem Weiterdrehen des Bedienteils gegen den Uhrzeigersinn aus der in Fig.3 und 4 gezeigten Stellung die Strebe 6a neben das Gehäuse 2 bewegt worden ist (die Strebe 6a das Gehäuse 2 also ganz überstrichen hat). Da der Magnet 3 nicht mehr mitbewegt werden kann, erhöht sich mit weitergehender Drehung der Abstand zu der Strebe 6a, während sich die folgende Strebe 6b annähert. Ab einer bestimmten Drehung befindet sich die Strebe 6b näher an dem Magneten 3 als die Strebe 6a, so wie es in der zweiten Betätigungsstellung der Fall ist. Dann koppelt der Magnet 3 dominant mit der zweiten Strebe 6b und bewegt sich aus der Anschlagsposition in eine Position, welche der Position der zweiten Strebe 6b entspricht (hier wieder der Ausgangsposition oder ersten Betätigungsstellung, wie durch die Pfeile angedeutet).

Durch eine Drehung des Bedienteils 1 um 60° gegen den Uhrzeigersinn lässt sich folglich eine sicher detektierbare Auslenkung des Magneten 3 in eine Anschlagsposition und eine Rückkehr in die Ausgangsposition erreichen. Dieser Vorgang kann beliebig oft wiederholt werden. Auch ist dieser Vorgang in die andere Drehrichtung analog durchführbar, wobei die Magnetfeldsensoren 10 die Richtung der Auslenkung des Magneten 3 feststellen können und die Drehrichtung für unterschiedliche Schaltvorgänge nutzbar ist (z.B. ein Ausschlag in eine Richtung für ein Erhöhen einer Leistungsstufe einer bestimmten Kochstelle des Kochfelds und ein Ausschlag in die andere Richtung für ein Erniedrigen der Leistungsstufe).

Der Übergang von der ersten Betätigungsstellung in die zweite Betätigungsstellung ist haptisch erfassbar als auch akustisch vernehmbar, was eine Rückmeldung an den Bediener verbessert. Das Anschlagsgeräusch mag durch ein Füllen des Innenraums 4 mit einem Dämpfungsmedium 11 (z.B. einem Gel oder einer Flüssigkeit) gedämpft werden.

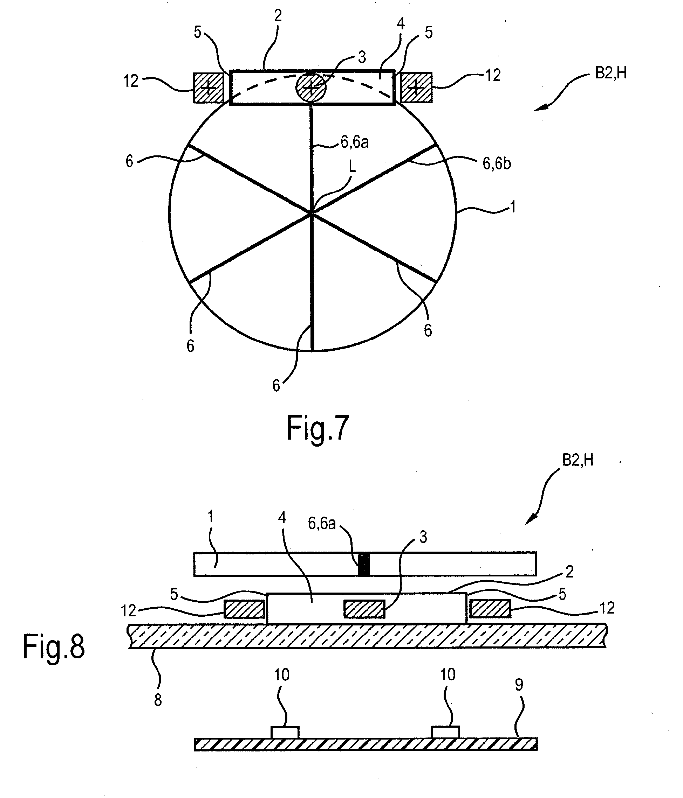

**Fig.7** zeigt in einer Ansicht von unten ein Bedienteil 1 und ein Gehäuse 2 mit einem darin enthaltenen Magneten 3, einer Bedienvorrichtung B2 gemäß einem zweiten Ausführungsbeispiel. **Fig.8** zeigt die Bedienvorrichtung B2 als Schnittdarstellung in Seitenansicht.

Die Bedienvorrichtung B2 ist ähnlich zu der Bedienvorrichtung B1 aufgebaut, unterscheidet sich aber von der Bedienvorrichtung B1 dadurch, dass zum Dämpfen des Aufschlags des Magneten 3 nun kein Dämpfungsmedium 11 in dem Innenraum 4 vorhanden ist, sondern ortsfest außerhalb des Gehäuses 5 an den als Anschlag dienenden Seitenflächen 5 Magnete (auch "Anschlagsmagnete" 12 genannt) vorhanden sind, welche den in dem Gehäuse 2 befindlichen Magneten 3 abstoßen. Dadurch wird zumindest kurz vor dem Anschlag des Magneten 3 dieser abgebremst und folglich das Aufschlagsgeräusch verringert. Die Magnete können allgemein z.B. als Monopolmagnete oder Dipolmagnete ausgebildet sein.

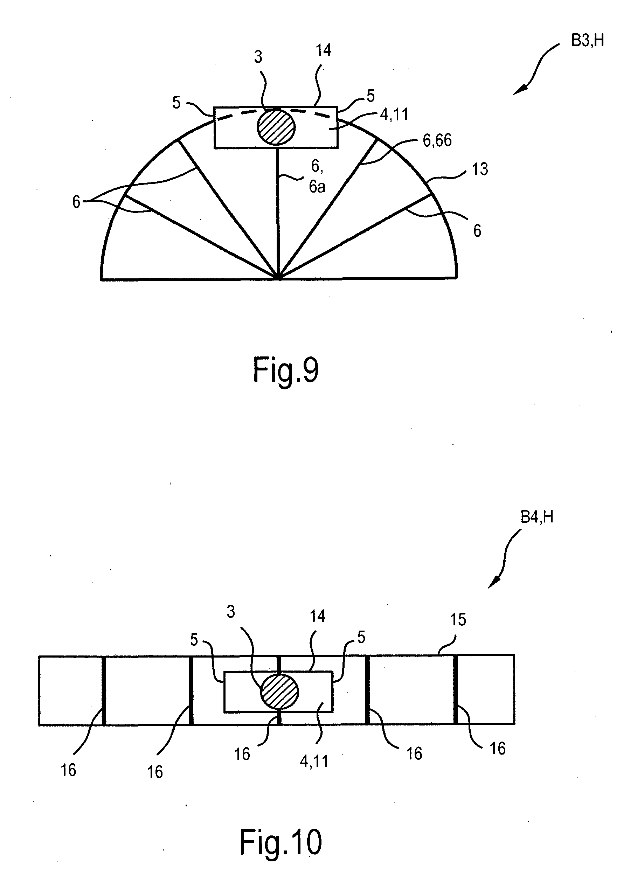

**Fig.9** zeigt in einer Ansicht von unten ein Bedienteil 13 und ein Gehäuse 14 mit einem darin enthaltenen Magneten 3, welche einen Teil einer Bedienvorrichtung B3 gemäß einem dritten Ausführungsbeispiel darstellen. Die Bedienvorrichtung B3 ist ähnlich zu der Bedienvorrichtung B1 aufgebaut, unterscheidet sich aber von der Bedienvorrichtung B1 dadurch, dass die Streben 6 des Bedienteils 13 (aus Draufsicht oder aus Sicht von unten) nicht mehr drehsymmetrisch um die Drehachse L angeordnet hat, sondern winkelgleich verteilt nur über einen Halbkreis. Dadurch werden einem Bediener hier drei Ausschläge, und damit maximal drei Schaltvorgänge, des Magneten in jeder Richtung nahegelegt. Die Zahl der Streben 6 ist dazu doppelt so hoch wie bei den Bedienvorrichtungen B1 und B2. Um weiterhin eine eindeutige Zuordnung der Streben 6 zu dem Magneten 3 gewährleisten zu können, ist das Gehäuse 14 kürzer ausgeführt als das Gehäuse 2 der Bedienvorrichtungen B1 und B2. Entsprechend sind auch die Magnetfeldsensoren 10 näher zueinander angeordnet.

Eine feste Beschränkung der Zahl der Auslenkungen des Bedienteils 13 kann beispielsweise durch mechanische Anschläge für das Bedienteil (o.Abb.) erreicht werden.

**Fig.10** zeigt in einer Ansicht von unten ein Bedienteil 15 und ein Gehäuse 14 mit einem darin enthaltenen Magneten 3, welche einen Teil einer Bedienvorrichtung B4 gemäß einem vierten Ausführungsbeispiel darstellen. Die Bedienvorrichtung B4 ist ähnlich der Bedienvorrichtung B1 aufgebaut, außer dass nun das Bedienteil 15 ein längsverschiebliches Bedienteil 15 ist (z.B. in der gezeigten Darstellung verschieblich von links nach rechts oder umgekehrt) und beispielhaft fünf parallel und äquidistant angeordnete Koppelelemente in Form ferromagnetischer Streben 16 aufweist. Die Auslenkung wird also durch eine lineare Verschiebung des Bedienteils 15 entlang seiner Längserstreckung erreicht, wobei hier in jede Richtung zwei Auslenkungen des Magneten 3 möglich sind.

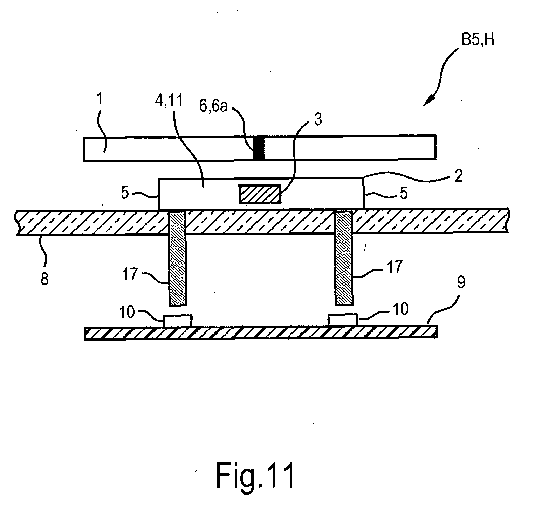

**Fig.11** zeigt als Schnittdarstellung in Seitenansicht eine Bedienvorrichtung B5 gemäß einem fünften Ausführungsbeispiel. Die Bedienvorrichtung B5 ist ähnlich der Bedienvorrichtung B1 aufgebaut, außer dass nun unterhalb des Gehäuses 2, genauer gesagt unter einer Anschlagsposition des Magneten 3, jeweils ein Magnetfeld-Führungselement in Form eines Stifts 17 aus einem Mu-Metall (einer weichmagnetischen Nickel-Eisen-Legierung mit meist ca. 75-80 % Nickel und hoher magnetischer Permeabilität) vorhanden ist. Die Stifte 17 sind dazu jeweils durch die Trägerplatte 8 an das Gehäuse 2 herangeführt und enden auf ihrer anderen Seite kurz über den jeweiligen Magnetfeldsensor 10. Die Stifte 17 lenken das von dem an der Anschlagsposition befindlichen Magneten 3 erzeugte Magnetfeld zu dem Magnetfeldsensor 10, wodurch sich dessen Messempfindlichkeit erhöht.

Selbstverständlich ist die vorliegende Erfindung nicht auf die gezeigten Ausführungsbeispiele beschränkt.

So müssen die Streben nicht gleichmäßig (mit gleichem Winkelabstand oder gleichem Abstand) angeordnet sein.

### Bezugszeichenliste

- 1: Bedienteil
- 2: Gehäuse
- 3: Magnet
- 4: Innenraum
- 5: Seitenwand
- 6: ferromagnetische Strebe
- 6a: ferromagnetische Strebe
- 6b: ferromagnetische Strebe
- 7:
- 8: Trägerplatte
- 9: Sensoreinrichtung
- 10: Magnetfeldsensor
- 11: Dämpfungsmedium
- 12: Anschlagsmagnet
- 13: Bedienteil
- 14: Gehäuse
- 15: Bedienteil
- 16: ferromagnetische Streben
- 17: Stift
- B1: Bedienvorrichtung
- B2: Bedienvorrichtung
- B3: Bedienvorrichtung
- B4: Bedienvorrichtung
- B5: Bedienvorrichtung
- H: Haushaltsgerät
- L: Drehachse

## Patentansprüche

1. Bedienvorrichtung (B1-B5) für ein Haushaltsgerät (H), aufweisend:
- eine Trägerplatte (8),
- ein ortsfest angeordnetes Gehäuse (2; 14) mit einem darin für eine begrenzte Strecke beweglich untergebrachten Magneten (3),
- ein oberhalb des Gehäuses (2; 14) angeordnetes bewegliches Bedienteil (1; 13; 15), welches dazu eingerichtet ist, mit dem Magneten (3) magnetisch zu koppeln und bei seiner Bedienung eine Bewegung des Magneten (3) in dem Gehäuse (2; 14) zu bewirken, und
- mindestens einen unterhalb der Trägerplatte (8) angeordneter Sensor (10), mittels dessen eine Position des Magneten (3) feststellbar ist,
**dadurch gekennzeichnet, dass**
- das Gehäuse (2; 14) oberhalb der Trägerplatte (8) angeordnet ist und dass
- das Bedienteil mehrere voneinander beabstandete Koppelelemente (6, 6a, 6b; 16) aufweist, welche jeweils dazu eingerichtet sind, mit dem Magneten (3) magnetisch zu koppeln, und welche das Gehäuse (2; 14) bei einer Bedienung des Bedienteils (1; 13; 15) überstreichen können.

2. Bedienvorrichtung (B1-B5) nach Anspruch 1, **dadurch gekennzeichnet, dass**
- sich zu einem Zeitpunkt nur genau eines der Koppelelemente (6, 6a, 6b; 16) oberhalb des Gehäuses (2; 14) befindet und dass
in einer ersten Stellung des Bedienteils (1; 13; 15)
- sich ein erstes Koppelelement (6a; 16) in einer Position oberhalb des Gehäuses (2; 14) befindet und
- sich der Magnet (3) an einer korrespondierenden Position in dem Gehäuse (2; 14) befindet, und dass
bei einem Übergang zu einer zweiten Stellung des Bedienteils (1; 13; 15)
- das erste Koppelelement (6a) neben das Gehäuse (2; 14) bewegbar ist, so dass der Magnet (3) an das Gehäuse (2; 14) anschlägt, und
- ein zu dem ersten Koppelelement (6a; 16) benachbartes zweites Koppelelement (6b; 16) in eine Position oberhalb des Gehäuses (2; 14) bewegbar ist, so dass der Magnet (3) folgend aus dem Anschlag in eine Position bewegbar ist, welche der Position des zweiten Koppelelements (6b; 16) entspricht.

3. Bedienvorrichtung (B1-B3; B5) nach Anspruch 2, **dadurch gekennzeichnet, dass** das Bedienteil (1; 13) ein drehbares Bedienteil ist und mehrere sternförmig angeordnete Koppelelemente (6, 6a, 6b) aufweist.

4. Bedienvorrichtung (B4) nach Anspruch 2, **dadurch gekennzeichnet, dass** das Bedienteil (B4) ein längsverschiebliches Bedienteil ist und mehrere parallel angeordnete Koppelelemente (16) aufweist.

5. Bedienvorrichtung (B1-B5) nach einem der vorhergehenden Ansprüche, **dadurch gekennzeichnet, dass** die Koppelelemente 6, 6a, 6b; 16) ferromagnetische Streben sind.

6. Bedienvorrichtung (B1) nach einem der vorhergehenden Ansprüche, **dadurch gekennzeichnet, dass** das Gehäuse (2) mit einem Dämpfungsmedium (11) gefüllt ist.

7. Bedienvorrichtung (B2) nach einem der vorhergehenden Ansprüche, **dadurch gekennzeichnet, dass** ortsfest an einer Außenseite mindestens eines Anschlagsbereichs (5) des Gehäuses (2) ein Magnet (12) angeordnet ist, welcher den Magneten (3) in dem Gehäuse abstößt.

8. Bedienvorrichtung (B1-B5) nach einem der vorhergehenden Ansprüche, **dadurch gekennzeichnet, dass** ein Innenraum (4) des Gehäuses (2; 14) eine Führung für den darin vorhandenen Magneten (3) darstellt.

9. Bedienvorrichtung (B1-B5) nach einem der vorhergehenden Ansprüche, **dadurch gekennzeichnet, dass** der mindestens eine Sensor (10) mindestens einen Magnetfeldsensor umfasst.

10. Bedienvorrichtung (B1-B5) nach einem der vorhergehenden Ansprüche, **dadurch gekennzeichnet, dass** der mindestens eine Sensor (10) mindestens einen optischen Sensor umfasst.

11. Bedienvorrichtung (B5) nach einem der vorhergehenden Ansprüche, **dadurch gekennzeichnet, dass** die Bedienvorrichtung (B5) ein Magnetfeld-Führungselement (17), z.B. einen Stift aus Weicheisen oder einem Mu-Metall aufweist, welches das von dem Magneten (3), insbesondere das von dem sich am Anschlag befindlichen Magneten, erzeugte Magnetfeld lokal stärker oder verstärkt führt.

12. Bedienvorrichtung (B1-B5) nach einem der vorhergehenden Ansprüche, **dadurch gekennzeichnet, dass** das Bedienteil (1; 13; 15) abnehmbar ist.

13. Verfahren zum Bedienen eines Haushaltsgeräts (H), **dadurch gekennzeichnet, dass** eine Position eines beweglichen Bedienteils (1; 13; 15) eine Position eines für eine begrenzte Strecke innerhalb eines ortsfest angeordneten Gehäuses (2; 14) beweglich untergebrachten Magneten (3) bestimmt, wobei das Bedienteil (1; 13; 15) oberhalb des Gehäuses (2; 14) angeordnet ist und dazu eingerichtet ist, mit dem Magneten (3) magnetisch zu koppeln und bei seiner Bedienung eine Bewegung des Magneten (3) in dem Gehäuse (2; 14) zu bewirken, und
- mit einer Bewegung des Bedienteils (1; 13; 15) der Magnet (3) aus einer in dem Gehäuse (2; 14) frei beweglichen Position in Anschlag mit dem Gehäuse (2; 14) gebracht wird, indem der Magnet (3) mit einem Koppelelement (6, 6a; 16) des Bedienteils (1; 13; 15) mitgenommen wird, wobei das Koppelelement (6, 6a; 16) mit dem Magneten (3) berührungslos koppelt,
- ein Vorhandensein des Magneten (3) in dem Anschlag detektiert wird und folgend
- mit einer weitergehenden Bewegung des Bedienteils (1; 13; 15) der Magnet (3) aus dem Anschlag in eine in dem Gehäuse (2; 14) frei bewegliche Position zurückgebracht wird, indem der Magnet (3) von dem Koppelelement (6, 6a; 16) entkoppelt wird und mit einem nachfolgenden, beabstandeten Koppelelement (6, 6b; 16) koppelt.

## Claims

1. Operating device (B1-B5) for a domestic appliance (H), having:
- a carrier plate (8),
- a housing (2; 14) disposed in a fixed location with a magnet (3) accommodated therein, movable for a restricted distance,
- a movable control part (1; 13; 15) disposed above the housing (2; 14) which is configured to magnetically couple with the magnet (3) and, during its operation, to bring about a movement of the magnet (3) in the housing (2; 14), and
- at least one sensor (10) disposed below the carrier plate (8), by means of which a position of the magnet (3) is able to be determined,
**characterised in that**
- the housing (2; 14) is disposed above the carrier plate (8) and that
- the operating part has a number of coupling elements (6, 6a, 6b; 16) spaced apart from one another, which are each configured to couple magnetically with the magnet (3) and which can slide over the housing (2; 14) during operation of the operating part (1; 13; 15).

2. Operating device (B1-B5) according to claim 1, **characterised in that**
- only precisely one of the coupling elements (6, 6a, 6b; 16) is located above the housing (2; 14) at any given time and that
in a first setting of the operating part (1; 13; 15)
- a first coupling element (6a; 16) is located in a position above the housing (2; 14) and
- the magnet (3) is located at a corresponding position in the housing (2; 14), and that on transition to a second setting of the operating part (1; 13; 15)
- the first coupling element (6a) is able to be moved next to the housing (2; 14) so that the magnet (3) stops against the housing (2; 14), and
- a second coupling element (6b; 16) adjacent to the first coupling element (6a; 16) is able to be moved into a position above the housing (2; 14), so that the magnet (3) is consequently able to be moved from the stop into a position which corresponds to the position of the second coupling element (6b; 16).

3. Operating device (B1-B3; B5) according to claim 2, **characterised in that** the operating part (1; 13) is a rotatable operating part and has a number of coupling elements (6, 6a, 6b) disposed in a star shape.

4. Operating device (B4) according to claim 2, **characterised in that** the operating part (B4) is an operating part able to be moved longitudinally and has a number of coupling elements (16) disposed in parallel.

5. Operating device (B1-B5) according to one of the preceding claims, **characterised in that** the coupling elements (6, 6a, 6b; 16) are ferromagnetic bars.

6. Operating device (B1) according to one of the preceding claims, **characterised in that** the housing (2) is filled with a damping medium (11).

7. Operating device (B2) according to one of the preceding claims, **characterised in that** a magnet (12) is disposed in a fixed location on an outer side of at least one stop area (5) of the housing (2), which repels the magnet (3) in the housing.

8. Operating device (B1-B5) according to one of the preceding claims, **characterised in that** an inner space (4) of the housing (2; 14) represents a guide for the magnet (3) present therein.

9. Operating device (B1-B5) according to one of the preceding claims, **characterised in that** the at least one sensor (10) comprises at least one magnetic field sensor.

10. Operating device (B1-B5) according to one of the preceding claims, **characterised in that** at least one sensor (10) comprises at least one optical sensor.

11. Operating device (B5) according to one of the preceding claims, **characterised in that** the operating device (B5) has a magnetic field guidance element (17), e.g. a pin made of soft iron or a mu-metal, which guides the magnetic field created by the magnet (3), especially the field created by the magnet located at the stop, locally more strongly or amplified.

12. Operating device (61-B5) according to one of the preceding claims, **characterised in that** the operating part (1; 13; 15) is removable.

13. Method for operating a domestic appliance (H), **characterised in that** a position of a movable operating part (1; 13; 15) defines a position of a magnet (3) accommodated movably for a restricted distance within a housing (2; 14) disposed at a fixed location, wherein the operating part (1; 13; 15) is disposed above the housing (2; 14) and is configured to couple magnetically with the magnet (3) and, during its operation, to bring about a movement of the magnet (3) in the housing (2; 14), and
- with the movement of the operating part (1; 13; 15) the magnet (3) is brought from a freely-movable position into contact with the housing (2; 14) by the magnet (3) being taken with it by a coupling element (6, 6a; 16) of the operating part (1; 13; 15), wherein the coupling element (6, 6a; 16) couples with the magnet (3) in a non-contact manner,
- the presence of the stopped magnet (3) is detected and consequently
- with a further movement of the operating part (1; 13; 15), the magnet (3) is brought back from the stop into a freely-movable position in the housing (2; 14) by the magnet (3) being decoupled from the coupling element (6, 6a; 16) and coupling with a subsequent coupling element (6, 6b; 16) spaced apart from said element.

## Revendications

1. Dispositif de commande (B1-B5) pour un appareil ménager (H), comprenant :
- une plaque de support (8),
- un boîtier (2 ; 14) disposé en position fixe avec un aimant (3) qui y est logé de manière mobile sur un trajet limité,
- un organe de commande mobile (1 ; 13 ; 15) disposé au-dessus du boîtier (2 ; 14), adapté pour un couplage magnétique avec l'aimant (3) et pour provoquer lors de son utilisation un déplacement de l'aimant (3) dans le boîtier (2 ; 14), et
- au moins un capteur (10) disposé au-dessous de la plaque de support (8), au moyen duquel une position de l'aimant (3) peut être détectée,
**caractérisé en ce que**
- le boîtier (2 ; 14) est disposé au-dessus de la plaque de support (8), et **en ce que**
- l'organe de commande comporte plusieurs éléments de couplage (6, 6a, 6b ; 16) espacés les uns des autres, qui sont adaptés pour un couplage magnétique avec l'aimant (3) et qui sont capables de venir balayer le boîtier (2 ; 14) lors d'une utilisation de l'élément de commande (1 ; 13 ; 15).

2. Dispositif de commande (B1-B5) selon la revendication 1, **caractérisé en ce que**
- à un moment seulement précisément un des éléments de couplage (6, 6a, 6b ; 16) se trouve au-dessus du boîtier (2 ; 14), et **en ce que**
dans une première position de l'organe de commande (1 ; 13 ; 15),
- un premier élément de couplage (6a ; 16) se trouve dans une position au-dessus du boîtier (2 ; 14) et
- l'aimant (3) se trouve à une position correspondante dans le boîtier (2 ; 14), et **en ce que**
lors d'un passage dans une deuxième position de l'organe de commande (1 ; 13 ; 15),
- le premier élément de couplage (6a) peut se déplacer contre le boîtier (2 ; 14) de sorte que l'aimant (3) bute contre le boîtier (2 ; 14), et
- un deuxième élément de couplage (6b ; 16), voisin du premier élément de couplage (6a ; 16), peut se déplacer dans une position au-dessus du boîtier (2 ; 14) de sorte que l'aimant (3), suite à la butée, peut se déplacer dans une position qui correspond à la position du deuxième élément de couplage (6b ; 16).

3. Dispositif de commande (B1-B3 ; B5) selon la revendication 2, **caractérisé en ce que** l'organe de commande (1 ; 13) est un organe de commande rotatif et qu'il comporte plusieurs éléments de couplage (6, 6a, 6b) disposés en étoile.

4. Dispositif de commande (B4) selon la revendication 2, **caractérisé en ce que** l'organe de commande (B4) est un organe de commande déplaçable longitudinalement et qu'il comporte plusieurs éléments de couplage (16) disposés en parallèle.

5. Dispositif de commande (B1-B5) selon l'une des revendications précédentes, **caractérisé en ce que** les éléments de couplage (6, 6a, 6b ; 16) sont des entretoises ferromagnétiques.

6. Dispositif de commande (B1) selon l'une des revendications précédentes, **caractérisé en ce que** le boîtier (2) est rempli d'un fluide d'amortissement (11).

7. Dispositif de commande (B2) selon l'une des revendications précédentes, **caractérisé en ce qu'**un aimant (12) est disposé en position fixe sur un côté extérieur d'au moins une zone de butée (5) du boîtier (2), lequel aimant (12) repousse l'aimant (3) dans le boîtier.

8. Dispositif de commande (B1-B5) selon l'une des revendications précédentes, **caractérisé en ce qu'**un espace intérieur (4) du boîtier (2 ; 14) constitue un guide pour l'aimant (3) qui y est présent.

9. Dispositif de commande (B1-B5) selon l'une des revendications précédentes, **caractérisé en ce que** le au moins un capteur (10) comprend au moins un capteur de champ magnétique.

10. Dispositif de commande (B1-B5) selon l'une des revendications précédentes, **caractérisé en ce que** le au moins un capteur (10) comprend au moins un capteur optique.

11. Dispositif de commande (B5) selon l'une des revendications précédentes, **caractérisé en ce que** le dispositif de commande (B5) comporte un élément de guidage (17) de champ magnétique, p. ex. une tige en fer doux ou en mumétal, qui dirige le champ magnétique produit par l'aimant (3), en particulier le champ magnétique produit par l'aimant en butée, de manière plus forte localement ou de manière renforcée.

12. Dispositif de commande (B1-B5) selon l'une des revendications précédentes, **caractérisé en ce que** l'organe de commande (1 ; 13 ; 15) est amovible.

13. Procédé de commande d'un appareil ménager (H), **caractérisé en ce qu'**une position d'un organe de commande mobile (1 ; 13 ; 15) détermine une position d'un aimant (3) logé de manière mobile sur un trajet limité dans un boîtier (2; 14) disposé en position fixe, l'organe de commande mobile (1 ; 13 ; 15) étant disposé au-dessus du boîtier (2 ; 14) et étant adapté pour un couplage magnétique avec l'aimant (3) et pour provoquer lors de son utilisation un déplacement de l'aimant (3) dans le boîtier (2 ; 14), et
- par un déplacement de l'organe de commande (1 ; 13 ; 15), l'aimant (3) est amené d'une position permettant un mouvement libre dans le boîtier (2 ; 14) en butée avec le boîtier (2 ; 14) par le fait que l'aimant (3) est entraîné par un élément de couplage (6, 6a ; 16) de l'organe de commande (1 ; 13 ; 15), l'élément de couplage (6, 6a ; 16) étant couplé sans contact à l'aimant (3),
- une présence de l'aimant (3) dans la butée est détectée, puis
- par un déplacement suivant de l'organe de commande (1 ; 13 ; 15), l'aimant (3) est ramené de la butée dans une position permettant un mouvement libre dans le boîtier (2 ; 14) par le fait que l'aimant (3) est découplé de l'élément de couplage (6, 6a ; 16) et couplé à un élément de couplage suivant (6, 6b ; 16) espacé.
